Europäisches Patentamt

European Patent Office

Office européen des brevets

(19)

(11) **EP 1 431 832 A1**

(12) **EUROPEAN PATENT APPLICATION**

(43) Date of publication:
**23.06.2004 Bulletin 2004/26**

(51) Int Cl.[7]: **G03F 9/00**

(21) Application number: **02080334.2**

(22) Date of filing: **16.12.2002**

| | |
|---|---|
| (84) Designated Contracting States:<br>**AT BE BG CH CY CZ DE DK EE ES FI FR GB GR IE IT LI LU MC NL PT SE SI SK TR**<br>Designated Extension States:<br>**AL LT LV MK RO** | (72) Inventor: **The designation of the inventor has not yet been filed** |
| (71) Applicant: **ASML Netherlands B.V.**<br>**5503 LA Veldhoven (NL)** | (74) Representative:<br>**Prins, Adrianus Willem, Mr. Ir. et al**<br>**Vereenigde,**<br>**Nieuwe Parklaan 97**<br>**2587 BN Den Haag (NL)** |

(54) **Lithographic apparatus and device manufacturing method**

(57)   A substrate is aligned in a lithographic apparatus using an optical interference arrangement and an alignment structure on a substrate. The optical interference set up produces measurement light whose spatially averaged intensity varies as a function of a phase of the spatially periodic alignment structure relative to lithographic apparatus. Alignment involves two steps. First, in order to find the alignment structure, information is determined about amplitudes of periodic variations of intensity of the measurement light from the interference arrangement over a range of relative positions that exceeds the extent of the alignment structure. Secondly, with measurement light from around a position of maximum amplitude the phase of the spatially periodic alignment structure relative to the reference position is determined. The phase is used to control a relative position of the substrate table and the patterning means during projection of a patterning beam.

Fig. 2

EP 1 431 832 A1

**Description**

The present invention relates to a lithographic projection apparatus comprising

- a radiation system for providing a projection beam of radiation;
- a support structure for supporting patterning means, the patterning means serving to pattern the projection beam according to a desired pattern;
- a substrate table for holding a substrate with an alignment structure with spatially periodical optical properties thereon;
- an alignment subsystem for positioning the substrate table relative to the patterning means, the alignment subsystem comprising

   - an optical interference arrangement, for optically processing light reflected or transmitted by the alignment structure, to produce measurement light whose intensity varies with a phase of the spatially periodic alignment structure relative to a reference position defined relative to the patterning means;
   - a sensor for measuring intensity information of the measurement light
   - phase determining means for determining the phase from the intensity information;
   - an actuator for controlling a relative position of the substrate table and the patterning means based on the phase;

- a projection system for projecting the patterned beam onto a target portion of the substrate,

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.
Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Before the pattern can be projected onto the substrate, the substrate has to be accurately positioned relative to the patterning means, so that the pattern will be projected onto the substrate accurately at a required position. In modem semi-conductor manufacturing this positioning has to be realized with nanometer accuracy.

US patent No 5,477,057 and European patent application No EP 1148390 describe such alignment, using a phase grating alignment system. Such a system uses a substrate that includes an alignment structure with periodically variable optical properties. The phase grating alignment system measures the phase of the period of the alignment structure relative to some reference position that is defined (directly or indirectly) relative to the patterning means. From the phase, a measurement of the position of the substrate is obtained.

The phase measurement is realized by incorporating the alignment structure in an optical interference arrangement that outputs light with an intensity that depends on the phase. The interference arrangement contains for example an imaging element that selects light diffracted by the alignment structure in an selected order of diffraction and images the selected light onto a reference structure in the lithographic apparatus. The reference structure has spatially periodically variable optical properties, with a period that corresponds to the period of the image of the alignment structure. As a result, the light output through the reference structure forms a kind of Moirée pattern. This pattern varies as the image of the alignment structure moves relative to the reference structure, dependent on the extent to which the image of the least reflective parts of the periods of the alignment structure coincide with the least transmissive parts of the periods of the reference structure. As a result the spatially averaged intensity of the output light varies periodically as a function of the position of the substrate.

A similar periodic variation can also be realized without a reference structure. European patent application No. EP 1148390 describes how interference may be used between light from the alignment structure that reaches a detector along two paths which correspond to images of the alignment structure that have been rotated 180 degrees with respect to one another. In this case, the center of that rotation serves to provide a defined position relative to the lithographic apparatus and the detected light intensity varies periodically as a function of the position of the substrate relative to the defined position.

In such interference arrangement the periodic variation of the averaged intensity can be measured without requiring a detector with high spatial resolution. The measurement of the intensity of the output light makes it possible to assign phase values to different positions of the alignment structure. The phase values in turn are used for accurate positioning of the substrate in the direction of periodical variation of the reflective properties of the alignment structure.

Through this type of optical processing of the information from the alignment pattern a high alignment accuracy can be realized. Selection of an individual order of diffraction eliminates noise that does not have the spatial frequency of the alignment structure. Compared to alignment techniques that use electronic pattern recognition of images of semiconductor wafers such optical filtering techniques realize accurate and low-noise alignment with detection and control circuits that are less critical for the alignment. However, this positioning technique has the problem that it only works when sufficiently large alignment structures and/or reference structures can be used so that the substrate can be initially positioned so that the alignment structure is imaged onto the reference structure. Large alignment structures and/or reference structures are expensive. Therefore it is desirable to reduce the area of the alignment structures and/or the reference structures. However, it has been found that below a certain area the structures, although still suitable for accurate positioning purposes, do not always work immediately because the image of the alignment structure has no overlap with the reference structure when the substrate is initially positioned.

It is an object of the present invention to provide for alignment of the substrate and the patterning means in which a smaller alignment structure on the substrate suffices to provide for alignment and pre-positioning.

This and other objects are achieved according to the invention in a lithographic apparatus as specified in the opening paragraph, characterized in the characterizing part of Claim 1. According to a further aspect of the invention there is provided a device manufacturing method according to Claim 6. According to the invention alignment under control of phase information involves a selection step, wherein a position of the substrate is selected so that the alignment structure and the reference structure are in an overlapping imaging relationship. The selection step involves determining the amplitude of intensity variations of the measurement light output from the interference arrangement and a search for a position of the substrate so that the alignment structure and the reference structure are in an overlapping imaging relationship. For this purpose, intensity measurements are subjected to different processing for the alignment step and for the pre-positioning step respectively. During alignment the phase of the periodic variations of the intensity is determined, during selection amplitude information of the variations is determined, preferably after filtering out variations that do not match variations due to relative movement of the alignment structure. This is done with a detector, which may be implemented as a suitably programmable computer that processes the same type of intensity information that is also used for phase measurement, but specialized detection hardware may be used as well. Subsequently, the alignment is performed at a position at or near a maximum of the measure of the amplitude.

Although a preferred embodiment is that radiation reflected from the alignment structure on the substrate is imaged onto the reference structure, radiation transmitted through the reference structure being detected, it should be understood that the claims are not limited to this embodiment. Instead of transmission though the reference structure reflection from the reference structure may be used and instead of imaging radiation from the alignment structure onto the reference structure one may use imaging the other way around from the reference structure onto the alignment structure on the substrate.

In an embodiment the amplitude of the variations as a function of position of the substrate is filtered with a filter that is selective for variations in the amplitude that correspond to the spatial frequency of the period of the alignment pattern and the filtered amplitudes are use in the search. One way of implementing filtering is to correlate the amplitude variations with a plurality of mutually displaced versions of a basic matching pattern. Correlation techniques are also often used to determine the phase, but in that case a single displaced version suffices. By using correlation techniques circuitry of a type that is used to determine the phase may also be used to determine the amplitude information. Preferably, a phase grating alignment technique is used for alignment, wherein only selected orders of diffraction from the alignment structure are used to determine the amplitudes.

In an embodiment the phase of the intensity variation of the measurement light is used for alignment in one direction, typically the direction in which the periods of the alignment structure follow one another. In this case further alignment structures on the substrate and/or reference structures in the lithographic apparatus may be used to control alignment in another direction transverse to said direction. Nevertheless, a single alignment structure and/or reference structure may be used for the two-dimensional search for a position of the substrate for the preposition prior to control dependent on the phase. This is possible because the amplitude of the intensity variations of the output radiation is indicative of overlap in two dimensions even when the phase is indicative of position in only one dimension.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including visible light, ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:

- Figure 1 depicts a lithographic projection apparatus
- Figure 2 depicts an alignment subsystem of the lithographic projection apparatus
  Figure 3 depicts a flow-chart for aligning a substrate and a mask pattern
  Figure 4 depicts a top view of part of a substrate
  Figure 5 depicts a detection signal
  Figure 6 depicts an alternative alignment subsystem

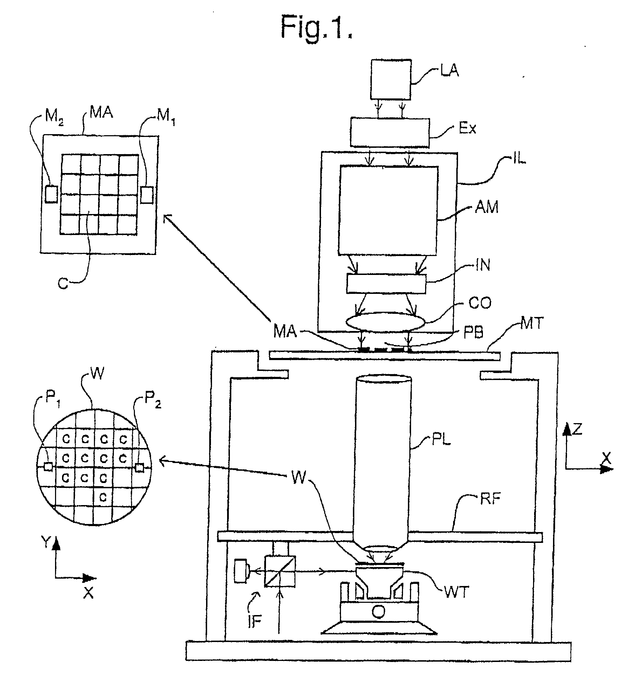

Figure 1 schematically depicts a lithographic projection apparatus 1 according to a particular embodiment of the invention. The apparatus comprises:

- a radiation system Ex, IL, for supplying a projection beam PB of radiation (e.g. UV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios. The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and

2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

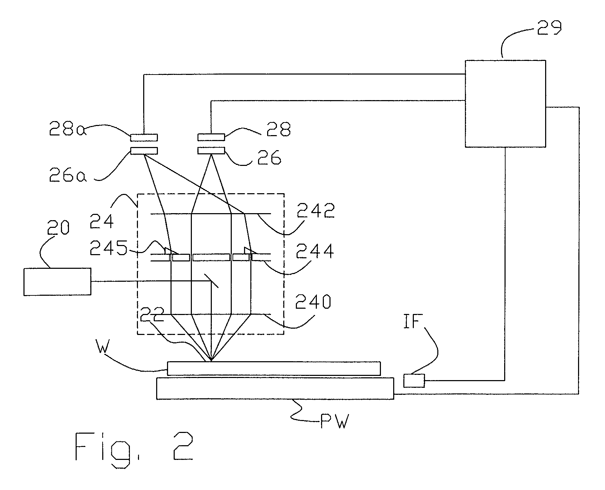

An alignment subsystem (not shown in figure 1) is included in the apparatus for accurately measuring the position of substrate W to ensure that substrate W is properly aligned during projection. The alignment subsystem may be needed for example because the location of substrate W on substrate table WT cannot be controlled with sufficient accuracy. Figure 2 schematically shows the alignment subsystem, containing an optical subsystem with a radiation source 20, an imaging structure 24, reference structures 26, 26a, detectors 28, 28a and a processing unit 29. Although processing unit 29 is shown as one element, it will be understood that processing unit 29 may be made up of a number of interconnected processors.

Radiation source 20, for example a laser, is arranged to generate a spot of light on an area 22 on substrate W. Imaging structure 24 contains a lens arrangement 240, 242 to image area 22 onto reference structure 26. Reference structure 26 has spatially periodic transmissive properties. Detector 28 is arranged to detect a spatially averaged intensity of radiation transmitted by reference structure 26. Detector 28 has an output coupled to an input of processing unit 29, which in turn has a control output coupled to second positioning means PW, which are coupled to substrate W. Interferometric measuring means IF have an output coupled to processing unit 29.

It will be understood that various changes may be made to the alignment subsystem without affecting its function. For example, mirrors may be added to be able to move elements of the alignment subsystem to more convenient locations. In one embodiment the alignment subsystem is immediately next to the projection lens, but it will be understood that the alignment subsystem may be further removed from the projection lens. It is not necessary that the substrate is in the path of the projection beam during alignment. In fact, another substrate, on a separate substrate table may even be in the path of the projection beam during alignment.

In operation radiation from radiation source 20 is reflected from area 22 and imaging structure 24 uses the reflected radiation to image area 22 onto reference structure 26. The imaged radiation is partially transmitted by reference structure 26 onto detector 28 which generates an electric signal that is indicative of the spatially averaged intensity of the transmitted radiation.

Processing unit 29 uses this electric signal to generate control signals for positioning means PW. This involves a number of stages (which may be executed by different elements (not shown) of processing unit 29). In a prepositioning stage processing unit 29 moves substrate W and the alignment system relative to one another so that an alignment structure is imaged onto reference structure 26. In an accurate positioning stage processing unit 29 accurately measures the position of substrate W and the alignment system relative to one another, i.e. it determines for which output value of Interferometric measuring means IF substrate W and alignment subsystem are in a specific alignment relative to one another. Subsequently, processing unit uses this measurement to control one or more positions with a predetermined offset to a position at which substrate W and the alignment subsystem are in alignment, to which substrate is moved for illumination with projection beam PB.

For accurate alignment substrate W contains an alignment structure with spatially periodic reflection properties in area 22. During accurate alignment this alignment structure is imaged onto reference structure 26. The spatially averaged amount of light transmitted by reference structure 26 depends periodically on the relative phase of the image of the alignment structure and reference structure 26.

Preferably, imaging structure 24 passes only selected pairs of orders of diffraction onto reference structure 26. As shown, imaging structure 24 has been designed to filter out selected orders of diffraction from area 22. For this purpose imaging element contains lenses 240, 242 with a diffraction order filter 244 in between. A first lens 240 maps light diffracted in respective directions to respective positions on diffraction order filter 244, which transmits only light from selected positions. A second lens forms an image of area 22 from the transmitted light. Thus only selected pairs of orders of diffraction are used for imaging onto reference structure 26. Without such selective transmission position measurement is in principle also possible, but it has a worse signal to noise ratio.

Also preferably, as shown, a number of pairs of diffraction orders of the light from area 22 are treated separately. For this purpose wedges 246 are provided to ensure that different pairs of orders are imaged onto different reference structures 26, 26a, each provided with its own detector 28. 28a. Although only two reference structures 26, 26a and corresponding detectors 28, 28a have been shown, for pairs of diffraction orders +-1 and +-2 respectively. It should be understood that in practice a larger number of diffraction orders, for example seven pairs of diffraction orders +-n (n=1,2,3,4,5,6,7..) may be treated separately, each with its own reference structure and detector.

Although single elements 240, 242 have been shown for the sake of simplicity, it should be understood that in practice the imaging structure 24 may comprise a combination of lenses or imaging mirrors.

Furthermore, although a configuration has been shown wherein radiation is first reflected from substrate W and then transmitted through reference structure 26 before detection, it should be appreciated that other configurations may be used. For example, radiation reflected off reference structure 26 may be detected and/or radiation transmitted through substrate W may be used if substrate W permits this. Similarly, radiation may be fed to reference structure 26 first (for reflection or transmission) before being fed to substrate W prior to detection. Also, of course, the invention is not limited to the perpendicular incidence shown in figure 2.

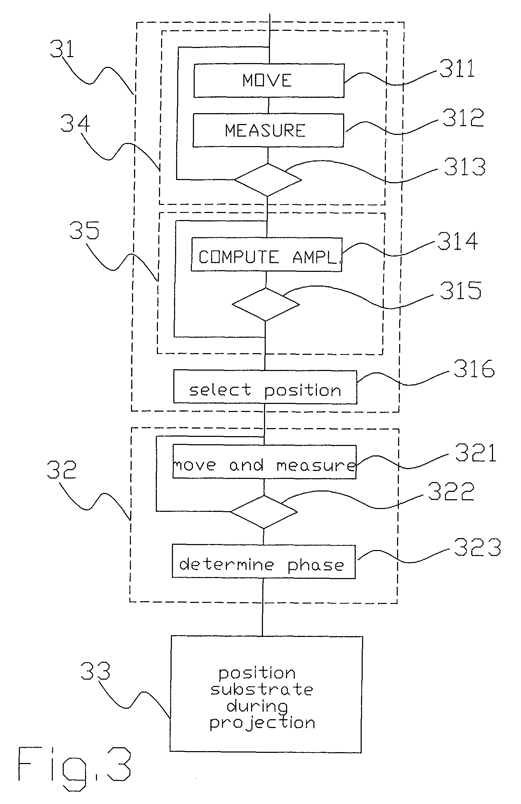

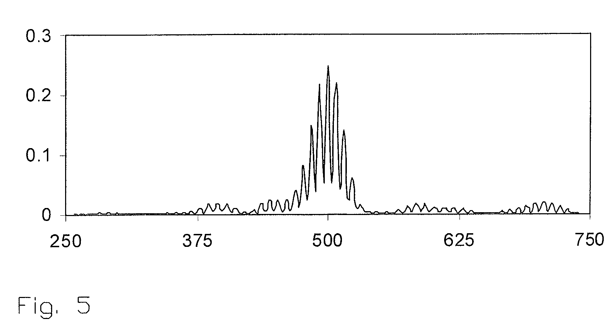

Figure 3 shows a flow chart of part of the operation of processing unit 29. The flow-chart contains a prepositioning stage 31, an alignment measurement stage 32 and a positioning-during-projection stage 33. The prepositioning stage contains a number of steps. The steps of the flow chart are implemented for example by providing a suitable program of instructions in an instruction memory (not shown) of processing unit 29 for execution by a conventional computer (not shown) in processing unit 29.

Prepositioning stage 31 contains a first, second and third step 34, 35, 316. In first step 34 of the prepositioning stage processing unit 29 causes substrate W to measure signals from detector 28 (and optionally from detector 28a and further detectors) at a series of positions. For this purpose first step 34 includes a first sub-step 311 of moving to a series of positions relative to the measuring subsystem and a second sub-step 312 in which an intensity signal from detector 28 is measured at these positions. The range of these positions is substantially larger than the size of reference structure 26. A third sub-step 313 ensures that the first and second sub-step are repeated for different positions.

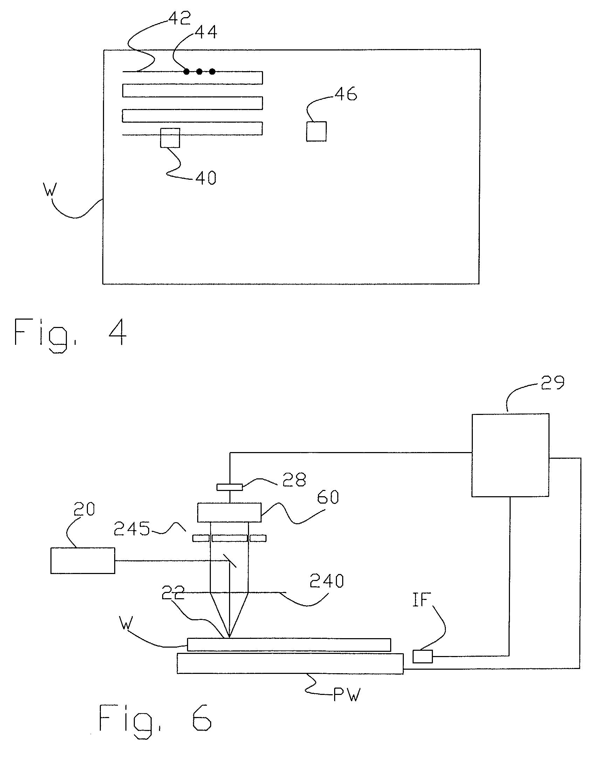

Figure 4 shows a top view of part of a substrate W with an alignment structure 40. A scanning path 42 has been indicated. Path 42 is not part of substrate W, but indicates successive locations 44 at which radiation source 20 provides spots of light on substrate which are imaged onto reference structure 26, during sub-step 311. Window 46 indicates the size of an area of points on substrate W that are imaged onto reference structure 26 at a single time. As can be seen the image of alignment structure 40 will overlap with reference structure 26 only for a limited number of positions along scanning path 42.

In a second step 35 of prepositioning stage 31 processing unit 29 computes amplitude information for a number of positions along scanning path 42. For this purposes second step 35 contains a first sub-step 314 in which the amplitude information is computed. A second sub-step 315 ensures that the first sub-step is repeated for a number of positions. Although first step 34 and second step 35 have been shown separately for the sake of clarity it should be appreciated that both steps may be integrated, the amplitude information being computed as the measurements come in. This reduces the need for memory for storing measurements that are still needed for amplitude computations.

Figure 5 shows an output signal of detector 28 as a function of position (in micrometers) along a horizontal part of scanning path 42 along substrate W as a continuous curve (although in practice measurements of the output may be performed only at certain sampling positions). At positions (around 500 micrometer) where the image of alignment structure 40 overlaps reference structure 26 the output signal varies periodically as a function of position. At other positions a more or less random variation of smaller amplitude occurs due to structures present in substrate W that are not alignment structures, such as circuit structures in the case of a semi-conducting manufacturing process. When only selected pairs of orders of diffraction are used, the more or less random variations involve amplitude and phase variations of a sine wave with a period corresponding to the selected orders of diffraction.

In the first sub-step 314 of the second step 35 processing unit 29 computes amplitude information of the variations of the output signal for a number of positions (with coordinates x,y on substrate W as measured by interferometric measuring means IF) along scanning path 42. The computation of the amplitude information involves determining a measure of the amplitude of the variations of the output signal. For substrates W that do not produce much output signal in the absence of the alignment structure it suffices to detect the amplitude, for example by taking the difference between minima and maxima, or by measuring the maximum deviation from the average output signal value. For other substrates W a certain amount of spatial filtering is preferred that suppresses the amplitudes of output signal variations that do not have the spatial frequency expected for the alignment structure. This may be realized for example by band pass filtering the output signal prior to amplitude measurement, or by correlation techniques that are selectively sensitive for the expected output signal from alignment structure 40.

As an example of the computation in first sub-step 313 of second step 35 processing unit 29 computes the amplitude information according to

$$A2(x,y) = (\text{Sum } \cos(k(x-x')) \; s(x',y'))^2 + (\text{Sum } \sin(k(x-x')) \; s(x',y'))^2$$

The sum is over locations with coordinates x', y', including at least a series of locations with different x' coordinate values spaced less than the width of alignment structure from one another. In the example A2(x,y) is the amplitude information A2 for a location with coordinates x,y as determined from the output s(x',y) of detector 28 with substrate positioned at a locations with coordinates x',y'. The parameter k is equal to $2\pi/p$, where p is the period of with which alignment structure 40 is imaged onto reference structure 26, 26a. The range of coordinates x',y' extends over a window that extends around the position with the coordinates x,y for which the amplitude information is computed. The size of the window can be selected freely. A larger range ensures greater frequency selectivity, making false detection of alignment structures less likely, but reduces position accuracy and vice versa. Preferably, the range of x', y' values that contributes to the sums is taken to have approximately the same size as alignment structure 40.

In a fourth step 316 of prepositioning stage 31 processing unit 29 uses the computed amplitude information to select a position (x0,y0) where the computed amplitude information is maximal as a function of a and y.

Although a formula for A2 has been given by way of example it should be appreciated without deviating from the inventions other types of formula may be used. For example, a formula for the derivative of A2 with respect to x may be computed to locate the maximum, or a product with a weighting functions W(x-x', x-y') included in the sums, W decreasing as x'and/or y' move away from x,y may be.

In principle, measurements from a detector 28 for a single pair of orders diffraction suffice to find the maximum. Optionally, similar determinations of amplitudes for different pairs of orders of diffraction may be used, either to compute a combined amplitude function or to confirm whether a maximum occurs for all pairs of orders of diffraction prior to using the location of the maximum.

Alignment measuring stage 32 is comparable to prepositioning stage 31, except that instead of an amplitude a phase is determined. Moreover, in alignment measuring stage 32 measurements are made preferably only at positions where the alignment structure is at a position from which it images onto reference structure 26.

In alignment measuring stage 32 processing unit 29 executes a first sub-step 321 similar to first and second sub-steps 311, 312 of prepositioning stage 31, involving moving to a number of locations and measurement of output signals of detector 28 with substrate W. A second sub-step 322 ensures repetition at a number of different locations relative to the alignment subsystem. These locations, have coordinates (x",y0) that are selected dependent on the position (x0,y0) produced in fourth step 316, with coordinates (x",y0) wherein x" is varied over a range around x0. In a third sub-step 323 processing unit 29 computes a phase value $\varphi$ from these measurements, for example using a formula like

$$\mathrm{tg}(\varphi) = a/b$$

where

$$a = \mathrm{Sum}\ \sin(k(x''-x0))\ s(x'',y'')$$

$$b = \mathrm{Sum}\ \cos(k(x''-x0))\ s(x'',y'')$$

The sum is over a range of locations with different x" which preferably extends over a range that is equal to the size of alignment structure 40, different x" values preferably being spaced by less than a period of reference structure 26. Choice of the y" values do not appreciably affect the computation, as long as they are within the size of the alignment structure, preferably a range of y" values is used in the sum. The computed phase value is proportional to the displacement between x0 and a reference position xr on substrate W divided by the period p with which alignment structure W is imaged onto reference structure 26:

$$\varphi = 2\pi(x0-xr)/p$$

Thus the phase value provides accurate position information of alignment structure 40 relative to the alignment sub-system. In positioning-during-projection stage 33 of the flow-chart processing unit 29 uses this information to position substrate W at a series of required positions relative to the patterning means.

Preferably, the determination of the phase is performed for a number of pairs of orders of diffraction and a combination of the computed phases is used to determine the position of the alignment structure.

It will be appreciated that different kinds of determinations of xr may be used. For example, a weight function W(x"-x0,y"-y0) may be used in the sums, or the some recursive process may be used to adjust x0 until "b" becomes zero, in which xr coincides with the adjusted x0.

It should be noted that the formulas for the phase $\varphi$ and the amplitude A2 use the same type of elements: summing cosine functions and sine functions. Nevertheless the formulas lead to two different types of information: the phase value $\varphi$ varies linearly substantially in the same way as a function of position x0, no matter how wide the range of positions (x",y") over which the sums are taken, the amplitude information A2, in contrast increases in strength as this range increased, be it with an accompanying decrease in position dependence. This makes the amplitude information suitable for searching among areas that do not contain the alignment structure and the phase information suitable for accurate positioning once it is known where the alignment structure 40 is located. The use of similar elements makes it possible to use much of processing unit 39 for both computations.

The determination of reference position xr from phase value φ is ambiguous, in the sense that any value of xr that differs by a integer multiple of the period p could be determined. Under some circumstances the prepositioning accuracy may be sufficient to identify a single xr value as the correct value, but generally this is not the case. Therefore one or more additional spatially periodic alignment structures are preferably provided on substrate W at predetermined relative positions with respect to alignment structure 40. The period or periods of this additional alignments structure or structures differ from the period of alignment structure 40. Similarly, the alignment sub-system is preferably provided with additional reference structures detectors etc. to determine the phase of the intensity variations due to displacement of the substrate relative to the alignment sub-system. Phase values determined in this way make it possible to increase the distance between ambiguous xr values up to a point that the prepositioning accuracy suffices to select the correct xr value.

In principle, the phase φ only provides information about the position of the alignment structure in a direction along which the optical properties of alignment structure 40 vary periodically. Therefore one or more further alignment structures, reference structures etc. are preferably provided with periodical spatial variation in a direction transverse to the period of alignment structure 40 (preferably perpendicular). These one or more further alignment structures are preferably provided at predetermined positions relative to alignment structure 40. During alignment stage 32 these one or more further alignment structures are used to obtain additional phase values for accurately positioning substrate W in the direction transverse to the direction perpendicular to the period of alignment structure 40.

Processing unit 29 preferably uses the position (x0,y0) selected in third step 316 control the positions of substrate W where the phase value of the additional alignment structure or structures and the one or more further alignment structures is determined, using amplitude information obtained by using at least one of the alignment structure, the additional alignment structures and the further alignment structures. Using a single one of the alignment structures for pre-positioning simplifies processing and is usually sufficiently accurate, both in a direction perpendicular to the period of that alignment structure and in directions transverse thereto. But when increased pre-positioning accuracy is required a combined amplitude value for different alignment structures may be used, for example by summing amplitude information obtained for different alignment structures, taking account of the predetermined offset of these structures on substrate W.

As described, alignment is performed in a number of distinct stages and steps. It will be understood that the decomposition into stages and steps merely serves to facilitate explanation of the alignment process. In practice the various stages and steps need not be distinct. For example, the phase be determined from stored intensity measurements that have been obtained before, after or concurrently with (or are indeed part of) the measurements that are obtained at a series of relative positions of the substrate and the alignment measuring system for determining the position of maximum amplitude. In this case, the determination of the location of maximum amplitude merely serves to select which of the stored intensity measurements should be used. Alternatively, separate intensity measurements performed at locations selected under control of the location of maximum amplitude may be used for determining the phase. This requires less storage space for measurements, but it increases the time needed for alignment, since substrate W has to be moved to the selected locations.

Furthermore, although it is a preferred embodiment to use a suitably programmed computer or set of computers for the determination of phase and amplitude, as well as the search for the relative position of substrate and alignment measuring system that leads to maximum amplitude, it will be understood that dedicated (not or only partly programmable) may be used to perform any one or a combination of these operations. For example, a digital signal processing circuit may be used to perform the filter operations that filter out intensity variations of the expected frequency and to compute the phase and amplitude. As another example, specialized hardware amplitude detection circuitry may be used, such as used for AM radio demodulation may be coupled to detector 28.

Figure 6 shows an alternative alignment system. Herein reference structure 26 has been omitted. Instead a rotating element 60 has been added, which combines light diffracted in orders of diffraction with mutually opposite sign n, -n rotating the image of the alignment structure of the opposite orders over 180 degrees relative to one another, e. g. rotating one over 90 degrees and the other over -90 degrees. Such a structure has been described in European patent application No. EP 1148390. The intensity of the combined light is measured at a detector 28. In this case no reference structure is needed in front of detector 28. The output of detector 28 may used in the way described for figure 2.

Whilst specific embodiments of the invention have been described above, it will be appreciated that the invention may be practiced otherwise than as described. The description is not intended to limit the invention.

**Claims**

1. A lithographic projection apparatus comprising:

   - a radiation system for providing a projection beam of radiation;
   - a support structure for supporting patterning means, the patterning means serving to pattern the projection beam according to a desired pattern;
   - a substrate table for holding a substrate with an alignment structure with spatially periodical optical properties thereon;
   - an alignment subsystem for positioning the substrate table relative to the patterning means, the alignment subsystem comprising

     - an optical interference arrangement, for optically processing light reflected or transmitted by the alignment structure, to produce measurement light whose intensity varies with a phase of the spatially periodic alignment structure relative to a reference position defined relative to the patterning means;
     - a sensor for measuring intensity information of the measurement light
     - phase determining means for determining the phase from the intensity information;
     - an actuator for controlling a relative position of the substrate table and the patterning means based on the phase;

   - a projection system for projecting the patterned beam onto a target portion of the substrate,

   **characterized in that** the alignment subsystem comprises

   - an amplitude detector for determining information about amplitudes of periodic variations of the intensity of the measurement light as a function of the relative position of the substrate table and the patterning means, the information about different amplitudes being obtained over a range of relative positions that extends over more than a size of the alignment structure;
   - searching means for searching for an alignment position that maximizes said amplitude among the range, the phase determining means being arranged to determine the phase from measurements of intensity information measured at a selected relative position or positions, selected dependent on the alignment position.

2. A lithographic projection apparatus according to Claim 1, wherein the amplitude detector comprises a frequency selective filter arranged to form a filtered signal from the intensity information determined as a function of position, selectively passing position dependent variations of the intensity information with a spatial frequency corresponding to the alignment structure, the detector determining the information about the amplitude from the filtered signal.

3. A lithographic projection apparatus according to any one of the preceding Claims wherein the actuator is arranged to use the phase to control one direction of the relative position, the direction corresponding to a direction along which the optical properties of the spatially periodical alignment structure vary periodically, said range of relative positions among which the amplitude is maximized being distributed in two directions on the substrate.

4. A lithographic projection apparatus according to any one of the preceding Claims, wherein the optical interference arrangement is arranged to measure selectively the intensity information of measurement light diffracted by the alignment structure in directions corresponding to a pair of opposite non-zero orders of diffraction.

5. A lithographic projection apparatus according to any one of the preceding Claims, wherein the optical interference arrangement comprises

   - a reference structure with spatially periodically varying reflective and/or transmissive properties;
   - an imaging element for creating an imaging relationship between the substrate and the reference structure, the reference structure having a period that corresponds to the period of the alignment structure when imaged onto the reference structure, the sensor measuring intensity information of measurement light that has been reflected and/or transmitted by both the reference structure and the alignment structure.

6. A device manufacturing method comprising the steps of:

   - providing a substrate that is at least partially covered by a layer of radiation-sensitive material, the substrate comprising an alignment structure with spatially periodically varying optical properties;
- providing a projection beam of radiation using a radiation system;
- using patterning means to endow the projection beam with a pattern in its cross-section; and
- aligning the substrate table relative to the patterning means, said aligning comprising

- incorporating the substrate in an optical interference arrangement, which optically processes light reflected or transmitted by the alignment structure, to produce measurement light whose intensity varies with a phase of the spatially periodic alignment structure relative to a reference position defined relative to the patterning means;
- measuring intensity information of the measurement light
- determining the phase from the intensity information;
- controlling a relative position of the substrate table and the patterning means based on the phase;

- projecting the patterned beam of radiation onto a target portion of the layer of radiation-sensitive material,

**characterized in that** said aligning comprises

- sensing intensities of the measurement light for successive relative positions including relative positions at which mutually non-overlapping available areas on the substrate contribute to the measurement light;
- determining information about amplitudes of periodic variations of intensity of the measurement light;
- searching for an optimal relative position that maximizes said amplitude information among the available areas;
- using the optimal relative position to select a measurement area from which the measurement light is used to determine the phase.

7. A device manufacturing method according to any one of Claims 6, comprising the steps of

- filtering the intensity information determined as a function of position with a frequency selective filter that selectively passes position dependent variations of the intensity information with a frequency corresponding to the alignment structure, and
- determining the information about the amplitude from the filtered signal.

8. A device manufacturing method according to Claim 6 or 7, wherein the alignment structure is spatially periodically variable along a single periodic direction, the phase being used to control one direction of the relative position, the one direction corresponding to said single periodic direction, the range of successive relative positions among which the amplitude is maximized being distributed in two directions on the substrate.

9. A device manufacturing method according to Claim 6, 7 or 8, comprising measuring the intensity information of measurement light diffracted by the alignment structure in selected directions corresponding to a pair of opposite non-zero orders of diffraction.

10. A device manufacturing method according to Claim 6, 7, 8 or 9, wherein the optical interference arrangement comprises an imaging element for creating an imaging relationship between the substrate and a reference structure with spatially periodically varying reflective and/or transmissive properties, the reference structure having a period that corresponds to the period of the alignment structure when imaged onto the reference structure, the method comprising measuring the intensity information from measurement light that has been reflected and/or transmitted by both the reference structure and the alignment structure.

# Fig.1.

Fig. 2

31

34

35

32

33

311 MOVE

312 MEASURE

313

314 COMPUTE AMPL.

315

316 select position

321 move and measure

322

323 determine phase

position
substrate
during
projection

Fig.3

Fig. 5

Fig. 4

Fig. 6

**European Patent Office**

## EUROPEAN SEARCH REPORT

Application Number

EP 02 08 0334

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,X | US 5 477 057 A (ANGELEY DAVID ET AL) 19 December 1995 (1995-12-19) * column 4, line 3 - column 8, line 48 * * figures * | 1,6 | G03F9/00 |
| A | US 5 754 300 A (OHTA KAZUYA ET AL) 19 May 1998 (1998-05-19) * column 6, line 7 - column 9, line 18 * * figures * | 1,6 | |
| A | US 5 026 166 A (VAN DER WERF JAN E) 25 June 1991 (1991-06-25) * column 4, line 28 - column 8, line 63 * * figures * | 1,6 | |
| D,A | EP 1 148 390 A (SVG LITHOGRAPHY SYSTEMS INC) 24 October 2001 (2001-10-24) * the whole document * | 1,6 | |
| A | PATENT ABSTRACTS OF JAPAN vol. 017, no. 653 (E-1469), 3 December 1993 (1993-12-03) -& JP 05 217835 A (NIKON CORP), 27 August 1993 (1993-08-27) * abstract * * figures * | 1,6 | TECHNICAL FIELDS SEARCHED (Int.Cl.7) G03F |

The present search report has been drawn up for all claims

| Place of search | Date of completion of the search | Examiner |
|---|---|---|
| THE HAGUE | 22 October 2003 | Aguilar, M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

EP 1 431 832 A1

**ANNEX TO THE EUROPEAN SEARCH REPORT
ON EUROPEAN PATENT APPLICATION NO.**                    EP 02 08 0334

This annex lists the patent family members relating to the patent documents cited in the above–mentioned European search report.
The members are as contained in the European Patent Office EDP file on
The European Patent Office is in no way liable for these particulars which are merely given for the purpose of information.

22-10-2003

| Patent document cited in search report | | Publication date | Patent family member(s) | | Publication date |
|---|---|---|---|---|---|
| US 5477057 | A | 19-12-1995 | CA | 2155045 A1 | 18-02-1996 |
| | | | DE | 69526890 D1 | 11-07-2002 |
| | | | DE | 69526890 T2 | 02-10-2002 |
| | | | EP | 0698826 A1 | 28-02-1996 |
| | | | JP | 8190202 A | 23-07-1996 |
| US 5754300 | A | 19-05-1998 | JP | 1299402 A | 04-12-1989 |
| | | | JP | 2081705 C | 23-08-1996 |
| | | | JP | 7119570 B | 20-12-1995 |
| US 5026166 | A | 25-06-1991 | NL | 8401710 A | 16-12-1985 |
| | | | CA | 1232981 A1 | 16-02-1988 |
| | | | DE | 3561677 D1 | 31-03-1988 |
| | | | EP | 0164165 A1 | 11-12-1985 |
| | | | JP | 2575621 B2 | 29-01-1997 |
| | | | JP | 60257450 A | 19-12-1985 |
| EP 1148390 | A | 24-10-2001 | US | 6628406 B1 | 30-09-2003 |
| | | | CA | 2338479 A1 | 20-10-2001 |
| | | | EP | 1148390 A2 | 24-10-2001 |
| | | | JP | 2001358068 A | 26-12-2001 |
| JP 05217835 | A | 27-08-1993 | NONE | | |

EPO FORM P0459

For more details about this annex : see Official Journal of the European Patent Office, No. 12/82

18